(19) Europäisches Patentamt
European Patent Office
Office européen des brevets

(11) Veröffentlichungsnummer: **0 165 423**
**B1**

(12) # EUROPÄISCHE PATENTSCHRIFT

(45) Veröffentlichungstag der Patentschrift: **20.04.88**

(51) Int. Cl.⁴: **H 01 B 3/30**, C 08 K 3/40, C 08 L 79/04

(21) Anmeldenummer: **85105483.3**

(22) Anmeldetag: **06.05.85**

(54) **Laminate aus Polyhydantoinen.**

(30) Priorität: **15.05.84 DE 3417941**

(43) Veröffentlichungstag der Anmeldung: **27.12.85 Patentblatt 85/52**

(45) Bekanntmachung des Hinweises auf die Patenterteilung: **20.04.88 Patentblatt 88/16**

(84) Benannte Vertragsstaaten: **DE FR GB IT**

(56) Entgegenhaltungen:
**DE - A - 1 230 568**
**DE - A - 2 161 043**
**FR - A - 1 536 923**
**FR - A - 2 248 221**
**FR - E - 92 852**
**FR - E - 92 853**
**GB - A - 1 480 631**
**US - A - 3 397 253**

**Die Akte enthält technische Angaben, die nach dem Eingang der Anmeldung eingereicht wurden und die nicht in dieser Patentschrift enthalten sind.**

(73) Patentinhaber: **BAYER AG, Konzernverwaltung RP Patentabteilung, D-5090 Leverkusen 1 Bayerwerk (DE)**

(72) Erfinder: **Jonas, Friedrich, Dr., Krugenofen 15, D-5100 Aachen (DE)**
Erfinder: **Müller, Richard, Dr., Birkenweg 23, D-5090 Leverkusen (DE)**
Erfinder: **Merten, Rudolf, Dr., Berta-von-Suttner-Strasse 55, D-5090 Leverkusen (DE)**
Erfinder: **Rottmaier, Ludwig, Ing.-grad., Bergstrasse 85, D-5068 Odenthal (DE)**

**EP 0 165 423 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft Laminate aus Polyhydantoinen.

Polyhydantoine sind bekannt (z.B. DE-OS-1 720 624). Sie finden hauptsächlich als Elektroisolierlacke, z.B. als Überzüge auf Leiterdrähten, Verwendung.

Polyhydantoine und deren Verwendung zur Herstellung von Laminaten sind vielfach beschrieben, u.a. in der US-A-3 397 253, DE-B-1 230 568, DE-A-2 161 043, FR-A-248 221.

Aus der DE-OS-2 333 523 ist bekannt, Amid-Imidgruppenhaltige Hydantoine zur Herstellung von Laminaten zu verwenden. Aus der US-PS-3 876 584 ist bekannt, Polyhydantoine der Formel I,

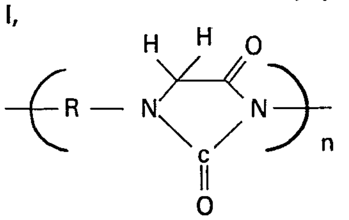
(I),

die in der wiederkehrenden kleinsten Einheit nur einen unsubstituierten Hydantoinring enthalten (head to head-Polymere), zur Laminierung zu verwenden. Das Eigenschaftsprofil derartiger Laminate ist jedoch nicht immer ganz befriedigend und ausreichend.

Es wurde nun gefunden, dass Laminate aus Polyhydantoinen mit sehr guten Eigenschaften erhalten werden, wenn die den Polyhydantoinen zugrundeliegenden wiederkehrenden kleinsten Einheiten zwei Polyhydantoinringe enthalten, die head to tail verknüpft sind.

Gegenstand der Erfindung sind daher Laminate aus faserigen Stoffen, head to tail verknüpften Polyhydantoinen und gegebenenfalls anderen organischen Polymeren und Verfahren zu ihrer Herstellung.

Geeignete head to tail verknüpfte Polyhydantoine entsprechen der Formel II

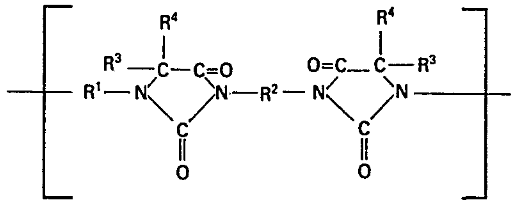
(II),

worin

$R^1$ und $R^2$ für einen gegebenenfalls mit Halogen wie Chlor und Brom und/oder $C_1$–$C_{10}$-(vorzugsweise $C_1$–$C_4$)-Alkylgruppen substituierten Alkylrest mit 2 bis 20 (vorzugsweise 2 bis 12) C-Atomen, einen Arylrest mit 6 bis 14 (vorzugsweise 6 bis 10) C-Atomen, einen Cycloalkylrest mit 5 bis 12 (vorzugsweise 5 bis 10) C-Atomen, einen Aralkylrest mit 7 bis 20 (vorzugsweise 7 bis 14) C-Atomen und einen Heteroatome wie N, O oder S im Ring enthaltenden Aryl- oder Cycloalkylrest steht, wobei die Aryl-, Cycloalkyl- und Aralkylreste durch $C_1$–$C_4$-Alkylenreste, O, S oder $SO_2$ unterbrochen bzw. und/oder mit einem bis vier $C_1$–$C_4$ Alkylresten substituiert sein können,

$R^3$ für Wasserstoff steht, und $R^4$ einen Rest der Formel $-CH_2-COR^5$, in der

$R^5$ für eine Aminogruppe, für eine $C_1$–$C_{10}$ (vorzugsweise $C_1$–$C_4$) Alkylamino, $C_1$–$C_{10}$ (vorzugsweise $C_1$–$C_4$) Dialkylamino-, $C_1$–$C_{10}$ (vorzugsweise $C_1$–$C_4$) Alkoxy- oder $C_6$–$C_{10}$ (vorzugsweise Phenoxy) Aroxygruppe steht,

bedeutet.

Besonders bevorzugte Reste sind:

$R^1$ und $R^2$: $(CH_2)_m$ mit m = 2,6

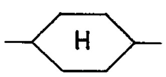 ; 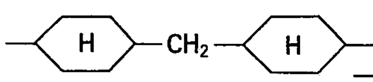 , 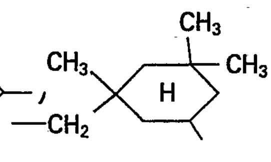

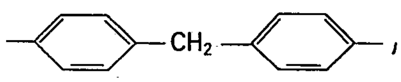 , 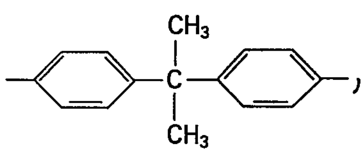 , 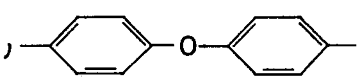

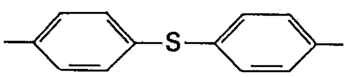 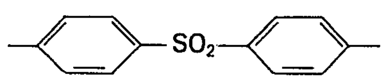

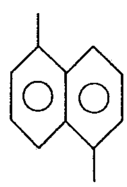 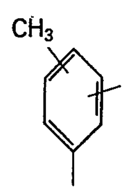 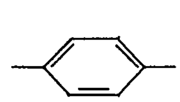 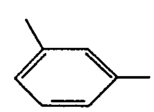

$R^4$: $-CH_2-COOCH_3$, $-CH_2COOC_2H_5$

Die Herstellung erfindungsgemäss verwendbarer Polyhydantoine kann nach an sich bekannten Verfahren erfolgen. So können z.B. aus Polyaminen und 1,2-Alkylendicarbonsäureestern hergestellte Asparaginsäureester mit Polyisocyanaten unter nachfolgender Cyclisierung umgesetzt werden (z. B. DE-PS-1 720 624). In der US-PS-3 397 253 wird beispielsweise die Herstellung von Polyhydantoinen durch Umsetzung von Glycinesterderivaten und Polyisocyanaten beschrieben. Eine Variante hiervon stellt die US-Patentschrift 4 298 515 dar, bei der die Mitverwendung von cyclischen Carbonsäureanhydridverbindungen beschrieben wird.

Bei der Herstellung der erfindungsgemässen Laminate ist es vorteilhaft, dass Polyhydantoinlösungen erhalten werden, die bei hohem Feststoffgehalt eine relativ niedrige Viskosität aufweisen und in einer in der Novolackchemie als «B-Zustand» bezeichneten Form vorliegen.

Dies erfolgt vorteilhafterweise so, dass die Polyhydantoine nicht vollständig auskondensiert werden, wobei die Kondensationszeiten bzw. -temperaturen bei den verschiedenen Polyhydantoinen unterschiedlich sind. So sollte bei der Reaktion zwischen Asparaginsäureestern und Polyisocyanaten die Kondensationstemperatur 200 °C nicht überschreiten, vorteilhaft sollte sie bei 130 bis 180 °C liegen.

Eine weitere Möglichkeit, niedrigviskose Polyhydantoine zu erhalten besteht darin, bei der Herstellung eine der Ausgangskomponenten, insbesondere das Polyisocyanat, im Überschuss einzusetzen. Dabei führt bereits ein Überschuss von 1 bis 50 Mol-% Isocyanat zu (verkappten) isocyanatgruppenhaltigen Polyhydantoinen, die beim Verpressen bei höherer Temperatur weiterreagieren und temperaturbeständige Polyhydantoinlaminate geben können.

Die Herstellung der Laminate kann in der Weise erfolgen, dass man fasrige Stoffe, z. B. Glasfasermatten, mit einer Lösung des Polyhydantoins, die gegebenenfalls noch andere organische Polymere und/oder Katalysatoren enthalten kann, tränkt. Anschliessend wird das Lösungsmittel verdunstet, die so erhaltenen, bei Raumtemperatur klebfreien, aufrollbaren Glasfasermatten in mehreren Lagen übereinandergelegt und unter Druck bei erhöhter Temperatur zum fertigen Laminat ausgehärtet.

Bei der hierbei erfolgenden Auskondensation des Polyhydantoins kann trotz der grossen Schichtdicke praktisch keine Blasenbildung beobachtet werden.

Geeignete fasrige Stoffe sind z. B. Glas-, Asbest-, Textil-, Quarz-, oder Kohlenstoffasern als Fäden, Vliese, Rovings, Matten oder Gewebe.

Als Lösungsmittel für die verwendeten Polymerlösungen können die für die Herstellung der Polyhydantoine verwendeten Lösungsmittel dienen.

Beispielsweise seien genannt: Amide wie Dimethylformamid, N-Methylpyrrolidon, Dimethylacetamid, Phenole wie Phenol und Kresol, Ether und Ester wie Diethylenglykolmonomethylether, Glykolmonomethyletheracetat, Glykolmonoethyletheracetat, Benzoesäuremethylester, Alkohole wie Benzylalkohol, Diacetonalkohol, Ketone wie Acetophenon, Cyclohexanon, Lactone wie Caprolacton, Butyrolacton. Sie können einzeln oder im Gemisch eingesetzt werden. Vorzugsweise werden Phenol, Kresol, Dimethylformamid, Dimethylacetamid, N-Methylpyrrolidon, Cyclohexanon, Butyrolacton verwendet.

Den Polymerlösungen können zusätzliche Verdünnungsmittel, z. B. Verschnitt-Lösungsmittel zugesetzt werden. Vorzugsweise werden chlorierte Kohlenwasserstoffe wie Methylenchlorid, Ethylenchlorid, Aromaten wie Toluol, Xylole, Ester wie Butylacetat, Methylglykolacetat, Ethylenglykolacetat oder Ketone wie Methylisobutylketon eingesetzt.

Als Beispiele organischer Polymerer, die den Polyhydantoinlösungen zugesetzt werden können, seien genannt z. B. Novolackharze, Polyepoxide, z. B. Trisglycidylisocyanurat, Trisglycidyltriazolidin-3,5-dion, Polyepoxidharze auf Bisphenol-A-Basis, Polyamidimide, Polyimide, Polyester, Polyamide, Polyesteramide, Polyacetale, Polyimidisocyanate.

Als Katalysatoren, die die Aushärtung der Laminate beschleunigen können, seien genannt: z. B. organische Basen wie Dabco®, Hexamethylentetramin, Metallsalze z. B. Zinnoctoat, Titantetrabutylat, Kupferethylhexanoat, Metallkomplexsalze z. B. Ni-acetylacetonat, Cu-acetylacetonat, Eisen-(III)acetylacetonat. Die Aushärtung der Laminate erfolgt im Temperaturbereich von 180 bis 400 °C, bevorzugt von 200 bis 350 °C, besonders bevorzugt von 220 bis 300 °C, unter Druck im Bereich von 0,5–100 $kp/cm^2$, bevorzugt 5–50 $kp/cm^2$. Die erforderliche Zeit liegt zwischen wenigen Minuten und mehreren Stunden, bevorzugt von 5 bis 60 Minuten.

Die so erhaltenen Laminate zeichnen sich durch hohe Temperaturbeständigkeit und hohe Erweichungstemperaturen bei sehr guten mechanischen Eigenschaften aus.

Eine spezielle Anwendung liegt z. B. auf dem Elektroniksektor, z. B. zur Herstellung von Leiterplatten für Elektronikbausteine, z. B. nach dem Multilayerverfahren.

Diese Leiterplatten können aus den Laminaten nach bekannten Technologien, z. B. durch Kaschieren mit Kupferfolien hergestellt werden.

Beispiele

Herstellung der Polyhydantoinlösungen

Polyhydantoinlösung A:

In einer Rührapparatur mit Innenthermometer, Rührer und Destillationsbrücke werden 576 g (4 Mol) Maleinsäuredimethylester in 1,670 g Dimethylformamid vorgelegt. Unter Rühren werden bei 5 bis 10 °C 232 g (2 Mol) Hexamethylendiamin in 490 g Dimethylformamid zugetropft. Es wird auf Raumtemperatur (20 bis 25 °C) erwärmt und ca. 20 h bei dieser Temperatur nachgerührt. Anschliessend werden bei Temperaturen unter 50 °C 535 g (2,14 Mol) 4,4'-Diisocyanatodiphenylmethan eingetragen und unter Rühren wie folgt aufgeheizt: 1 h 50 °C, 1 h 100 °C, 10 h 130 bis 150 °C, wobei ca. 125 g Methanol abdestillieren.

Man erhält 3,350 g Polyhydantoinlösung mit einem Feststoffgehalt von 34% und einer Viskosität von $\eta$ = 176 mPas.

Polyhydantoinlösung B:

In einer Rührapparatur mit Innenthermometer, Rührer und Destillationsbrücke werden 576 g (4 Mol) Maleinsäuredimethylester in 500 ml Methanol vorgelegt. Unter Rühren werden bei 5 bis 10 °C 232 g (2 Mol) Hexamethylendiamin in 200 ml Methanol zugetropft. Es wird auf Raumtemperatur (20 bis 25 °C) erwärmt und ca. 12 h bei dieser Temperatur gerührt. Anschliessend wird das Methanol bei Innentemperatur von max. 30 °C im Vakuum (ca. 20 mbar) abdestilliert. Nach Zugabe von 2,150 g Cyclohexanon werden bei Temperaturen unter 70 °C 504 g (2,016 Mol) 4,4'-Diisocyanatodiphenylmethan eingetragen und wie in Beispiel 1 beschrieben, aufgeheizt.

Man erhält 3,350 g Polyhydantoinlösung mit einem Feststoffgehalt von 34% und einer Viskosität von $\eta = 210$ mPas.

Herstellen der Laminate

Beispiel 1

Ein Glasseidengewebe mit einem Gewicht von 200 g/m$^2$ wird mit der Polyhydantoinlösung A imprägniert und das Lösungsmittel im Warmluftschrank bei 120 °C verdunstet. Die Verpressung der beharzten Trägerbahnen zu Laminaten erfolgt bei 240 °C in 30 min und einem Druck von 10 kp/cm$^2$.

Man erhält ein Laminat mit hoher Erweichungstemperatur und sehr guten mechanischen Eigenschaften.

Beispiel 2

Es wird wie in Beispiel 1 vorgegangen, unter Verwendung der Polyhydantoinlösung B. Die Verpressung erfolgt in 20 min bei 250 °C und 20 kp/cm$^2$.

Man erhält ein Laminat mit hoher Erweichungstemperatur und sehr guten mechanischen Eigenschaften.

Beispiel 3

Ein Glasseidengewebe mit einem Gewicht von 200 g/m$^2$ wird mit einer Mischung aus der Polyhydantoinlösung B und einem handelsüblichen 33%igen Polyamidimid (Resistherm® AJ 133 L der Firma Bayer) im Verhältnis 9:1 getränkt und wie in Beispiel 2 beschrieben verarbeitet.

Man erhält ein Laminat mit sehr hoher Erweichungstemperatur und sehr guten mechanischen Eigenschaften.

Beispiel 6

Ein Glasseidengewebe mit einem Gewicht von 200 g/m$^2$ wird mit einer Mischung aus der Polyhydantoinlösung B und aus der Polyhydantoinlösung C im Verhältnis 2:1 getränkt. Die Verpressung erfolgt in 30 min bei 250 °C und 20 kp/cm$^2$.

Man erhält ein Laminat mit sehr hoher Erweichungstemperatur und sehr guten mechanischen Eigenschaften.

**Patentansprüche**

1. Laminate bestehend aus head to tail verknüpften Polyhydantoinen der Formel II

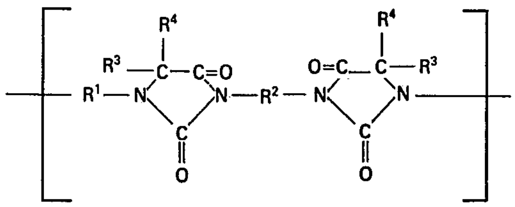

(II),

worin

$R^1$ und $R^2$ für einen gegebenenfalls mit Halogen wie Chlor und Brom und/oder $C_1$–$C_{10}$-Alkylgruppen substituierten Alkylrest mit 2 bis 20 C-Atomen, einen Arylrest mit 6 bis 14 C-Atomen, einen Cycloalkylrest mit 5 bis 12 C-Atomen, einen Aralkylrest mit 7 bis 20 C-Atomen und einen Heteroatome wie N, O oder S im Ring enthaltenden Aryl- oder Cycloalkylrest steht, wobei die Aryl-, Cycloalkyl- und Aralkylreste durch $C_1$–$C_4$-Alkylenreste, O, S oder $SO_2$ unterbrochen bzw. und/oder mit ein bis vier $C_1$–$C_4$-Alkylresten substituiert sein können,

$R^3$ für Wasserstoff steht und $R_4$ einen Rest der Formel $-CH_2-COR^5$, in der

$R^5$ für eine Aminogruppe, für eine $C_1$–$C_{10}$ Alkylamino, $C_1$–$C_{10}$ Dialkylamino-, $C_1$–$C_{10}$ Alkoxy- oder $C_6$–$C_{10}$ Aroxygruppe steht,

bedeutet, faserförmigen Füll- oder Verstärkungsmitteln und gegebenenfalls anderen organischen Polymeren.

2. Verfahren zur Herstellung von Laminaten auf Basis von Polyhydantoinen der Formel II, dadurch gekennzeichnet, dass man die Polyhydantoine der Formel II gegebenenfalls zusammen mit anderen organischen Polymeren mit faserförmigen Füll- oder Verstärkungsmitteln kombiniert, die erhaltene Masse formt und bei erhöhter Temperatur zu Laminaten aushärtet.

3. Leiterplatten für elektronische Bausteine, bestehend aus metallbeschichteten Laminaten nach Anspruch 1.

4. Verfahren zur Herstellung von Leiterplatten durch Kaschieren von Laminaten nach Anspruch 1 mit Metallfolien.

5. Verwendung von Laminaten nach Anspruch 1 zur Herstellung von Leiterplatten nach dem Multilayerverfahren.

**Claims**

1. Laminates consisting of polyhydantoins attached head-to-tail and corresponding to the following formula

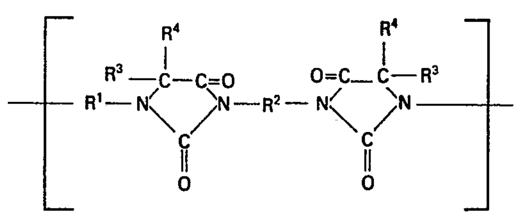

(II),

in which

$R^1$ and $R^2$ represent a $C_2$–$C_{20}$ alkyl radical optionally substituted by halogen, such as chlorine and bromine and/or $C_1$–$C_{10}$ alkyl groups, a $C_6$–$C_{14}$ aryl radical, a $C_5$–$C_{12}$ cycloalkyl radical, a $C_7$–$C_{20}$ aralkyl radical and an aryl or cycloalkyl radical containing hetero atoms, such as N, O or S in the ring, the aryl, cycloalkyl and aralkyl radicals optionally being interrupted by $C_1$–$C_4$ alkylene radicals, O, S or $SO_2$ and/or substituted by one to four $C_1$–$C_4$ alkyl radicals,

$R^3$ is hydrogen and

$R^4$ is a radical of the formula $-CH_2-COR^5$, in which

$R^5$ is an amino group, a $C_1$–$C_{10}$ alkylamino, $C_1$–$C_{10}$ dialkylamino, $C_1$–$C_{10}$ alkoxy or $C_6$–$C_{10}$ aroxy group, fibrous fillers and reinforcing materials and, optionally, other organic polymers.

2. A process for the production of laminates based on polyhydantoins corresponding to formula II, characterized in that the polyhydantoins corresponding to formula II, optionally together with other organic polymers, are combined with fibrous fillers or reinforcing materials, the mass obtained is molded and then hardened at elevated temperature to form laminates.

3. Circuit boards for electronic components, consisting of metal-coated laminates according to claim 1.

4. A process for the production of circuit boards by lamination of laminates according to claim 1 with metal foils.

5. The use of laminates according to claim 1 for the production of circuit boards by the multilayer process.

## Revendications

1. Stratifiés constitués de polyhydantoïnes à mode de liaison tête-à-queue, de formule II

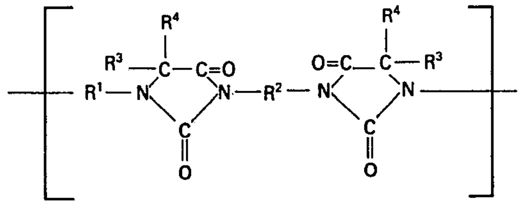

(II),

dans laquelle

$R^1$ et $R^2$ représentent un reste alkyle de 2 à 20 atomes de carbone éventuellement substitué avec un halogène tel que le chlore, le brome et/ou des groupes alkyle en $C_1$ à $C_{10}$, un reste aryle de 6 à 14 atomes de carbone, un reste cycloalkyle de 5 à 12 atomes de carbone, un reste aralkyle de 7 à 20 atomes de carbone et un reste aryle ou cycloalkyle contenant des hétéroatomes tels que N, O ou S dans le noyau, les restes aryle, cycloalkyle et aralkyle pouvant être interrompus par des restes alkylène en $C_1$ à $C_4$, O, S ou $SO_2$ et/ou pouvant être substitués avec 1 à 4 restes alkyle en $C_1$ à $C_4$,

$R^3$ représente de l'hydrogène et

$R^4$ est un reste de formule $-CH_2-COR^5$, dans laquelle

$R^5$ est un groupe amino, un groupe alkylamino en $C_1$ à $C_{10}$, dialkylamino en $C_1$ à $C_{10}$, alkoxy en $C_1$ à $C_{10}$ ou aroxy en $C_6$ à $C_{10}$,

de charges ou d'armatures fibreuses et, le cas échéant, d'autres polymères organiques.

2. Procédé de production de stratifiés à base de polyhydantoïnes de formule II, caractérisé en ce qu'on mélange les polyhydantoïnes de formule II, le cas échéant conjointement avec d'autres polymères organiques, avec des charges ou des armatures fibreuses, on met en forme le mélange obtenu et on le durcit en stratifiés à température élevée.

3. Plaques conductrices pour composants électroniques, constituées de stratifiés en revêtement métallique suivant la revendication 1.

4. Procédé de production de plaques conductrices par doublage de stratifiés suivant la revendication 1 avec des feuilles métalliques.

5. Utilisation de stratifiés suivant la revendication 1 pour la production de plaques conductrices par le procédé multicouche.